# EUROPÄISCHE PATENTSCHRIFT

(11) **EP 2 538 235 B1**
(45) Veröffentlichungstag und Bekanntmachung des Hinweises auf die Patenterteilung: **31.07.2013**
(21) Anmeldenummer: 11171354.1
(22) Anmeldetag: 24.06.2011
(51) Int. Cl.: G01R 33/18

(54) **Magnetostriktives Schichtsystem**
Magnetostrictive layer system
Système multicouche magnétostrictif

(43) Veröffentlichungstag der Anmeldung: 26.12.2012
(73) Patentinhaber: Christian-Albrechts-Universität zu Kiel, 24098 Kiel (DE)
(72) Erfinder: Lage, Enno, 24103 Kiel (DE); Meyners, Dirk, 24232 Schönkirchen (DE); Quandt, Eckhard, Prof. Dr.-Ing., 24226 Heikendorf (DE)
(74) Vertreter: Maiwald Patentanwalts GmbH

(56) Entgegenhaltungen:
- MARIAN VOPSAROIU ET AL: "A new magnetic recording read head technology based on the magneto-electric effect", JOURNAL OF PHYSICS D. APPLIED PHYSICS, IOP PUBLISHING, BRISTOL, GB, Bd. 40, Nr. 17, 7. September 2007 (2007-09-07), Seiten 5027-5033, XP020111811, ISSN: 0022-3727, DOI: 10.1088/0022-3727/40/17/003
- FETISOV Y K ET AL: "Ferrite-Piezoelectric Multilayers for Magnetic Field Sensors", IEEE SENSORS JOURNAL, IEEE SERVICE CENTER, NEW YORK, NY, US, Bd. 6, Nr. 4, 1. August 2006 (2006-08-01), Seiten 935-938, XP001546849, ISSN: 1530-437X, DOI: 10.1109/JSEN.2006.877989

## Beschreibung

Die Erfindung betrifft ein magnetostriktives Schichtsystem sowie ein Verfahren zu seiner Herstellung. Die Erfindung betrifft auch magnetoelektrische Sensoren.

Als Magnetostriktion eines Materials bezeichnet man seine Gestalts- und/oder Volumenänderung unter der Einwirkung eines äußeren Magnetfeldes. Im Fall der Gestaltsänderung erfolgt diese durch eine Längenänderung in Richtung des angelegten Magnetfeldes, die von einer Volumen erhaltenden Längenänderung senkrecht zur Feldrichtung begleitet wird (Joule-Magnetostriktion). Die Länge kann sich abhängig vom Material in Feldrichtung erhöhen bzw. verringern, was als positive bzw. negative Magnetostriktion bezeichnet wird.

Im Prinzip kann man bei allen ferromagnetischen oder ferrimagnetischen Materialien auch Magnetostriktion unterstellen. Bei einigen ist das Ausmaß der Magnetostriktion groß genug, dass sie als "magnetostriktive Materialien" eine technische Bedeutung erlangen. Als Beispiele seien hier ferromagnetische Übergangsmetalle (Fe, Ni, Co) und deren Legierungen, Verbindungen der Seltenen Erden Tb, Dy, Sm mit den ferromagnetischen Übergangsmetallen (z.B. TbFe₂, SmFe₂, TbDyFe) oder auch ferromagnetische Gläser vorwiegend enthaltend die Elemente Fe, Co, B oder Si in variierenden Anteilen, sogenannte magnetische Metgläser, genannt.

Die magnetostriktive Längenänderung wird ursächlich der Ausrichtung von magnetischen Elementardipolen entlang dem äußeren Magnetfeld zugeschrieben. Sie kann nach heutigem Wissen bis zu 2,5 mm/m = 2500 ppm bei Raumtemperatur betragen. Größere Dehnungen bis zu etwa 10 % werden aber in ferromagnetischen Formgedächtnislegierungen durch eine feldinduzierte Umorientierung von Martensitvarianten erreicht.

Magnetostriktion erfolgt grundsätzlich nicht in linearer Abhängigkeit von der externen Magnetfeldstärke. Vielmehr existiert z.B. eine Sättigungsfeldstärke Hₛ, jenseits der sich keine weitere Längenänderung des Materials mehr nachweisen lässt. Alle Elementardipole haben sich dann bereits völlig in Feldrichtung ausgerichtet, und eine weitere Erhöhung der Feldstärke ruft keine Reaktion des Materials mehr hervor.

Weiterhin ist Magnetostriktion invariant gegenüber Feldumkehr, d.h. bei gleicher Startkonfiguration der Magnetisierung und ohne Berücksichtigung von Hystereseeffekten erzeugen zwei einander entgegen gerichtete Felder gleicher Feldstärke dieselbe Längenänderung.

Die Magnetostriktionskurve λ(H) beschreibt die magnetostriktive Längenänderung eines Materials (oder eines Körpers aus dem Material) entlang der Magnetfeldrichtung mit Feldstärke H infolge einer Veränderung der Domänenverteilung im Material.

Im einfachsten Fall ohne magnetische Hysterese verläuft λ(H) durch den Ursprung (keine Änderung ohne Feld) und symmetrisch zu H = 0. Für große Beträge von H (> |Hₛ|) nimmt sie einen (positiven oder negativen) Sättigungswert an. Ihre Ableitung dλ/dH, die in der Literatur die Bezeichnung "Piezomagnetischer Koeffizient" trägt, weist zwischen H = 0 und H = ± Hₛ zwei Extrema auf, die bei H = ± H_{B} liegen. Dort liegen folglich Wendepunkte der Magnetostriktionskurve, und in der Umgebung dieser Wendepunkte - also für kleine Feldvariationen um H = ± H_{B} - ist die Magnetostriktion näherungsweise linear und maximal empfindlich.

Normalerweise zeigen magnetostriktive Materialien aber auch eine mehr oder weniger ausgeprägte Hysterese, und der Verlauf der Magnetostriktionskurve hängt damit auch von der Vorgeschichte ab. Insbesondere beim Zyklieren in einem externen Feld findet man, dass es einen Unterschied macht, ob man sich einer bestimmten Feldstärke H₀ von größeren oder kleineren Feldern her annähert. Es existieren zwei messbare Längenänderungen λ<(H₀) und λ>(H₀), die aber auch Symmetrie zu H = 0 zeigen: λ<(H₀) = λ>(-H₀) und λ<(-H₀) = λ>(H₀).

Es ist beispielsweise aus der US 2004/0126620 A1 bekannt, mehrlagige Verbundwerkstoffe aus magnetostriktiven und piezoelektrischen Materialschichten herzustellen, so genannte magnetoelektrische Kompositschichten. Diese sind u. a. sehr gut dazu geeignet, die Längenänderung des magnetostriktiven Materials vermöge der mechanischen Kopplung auf das piezoelektrische Material zu übertragen und dort eine Änderung des elektrischen Polarisationszustandes hervorzurufen. Die strukturell bedingte Ladungsverschiebung (Piezo-Effekt) erzeugt ein messbares elektrisches Feld bzw. eine Messspannung, welche direkt die Magnetostriktion und somit indirekt das externe Magnetfeld detektiert. Ein solches Komposit kann die Grundlage eines Magnetfeldsensors bilden, der gängig als magnetoelektrischer Sensor oder kurz als ME-Sensor bezeichnet wird.

Ein wichtiger Aspekt der Sensitivität von ME-Sensoren ist das Ausmaß der Magnetostriktion gegenüber kleinen Magnetfeldern (kleiner als Nano-Tesla, 1 Tesla = µ0 × 10.000 Oersted). Ein zweiter Aspekt ist die Linearität der Spannungsantwort auf Magnetfeldänderungen. Beides wird im Sinne der Messaufgabe optimiert, wenn es gelingt, die magnetostriktive Schicht des Komposites so einzurichten, dass sie für ein sehr kleines zu messendes Magnetfeld einen vergleichbaren piezomagnetischen Koeffizienten dλ/dH zeigt wie ansonsten im Bereich der Wendepunkte der Magnetostriktionskurve.

Aus der US 2004/0126620 A1 und zahlreichen anderen Druckschriften geht hervor, dass es zweckmäßig ist, ein so genanntes Stützfeld entlang der Schicht einzurichten. Das Stützfeld soll zeitlich konstant und im Bereich des Sensors homogen sein und entlang der Richtung, in der die Magnetostriktion optimiert werden soll, verlaufen. Bezogen auf einen ME-Sensor ist dies die Messrichtung, entlang der eine Komponente des Messfeldes zu bestimmen ist. Das Stützfeld wird auch als Bias-Magnetfeld bezeichnet und hat nach dem oben Gesagten möglichst in der gesamten Schicht den Betrag H_{B}.

Im Folgenden soll der "piezomagnetische Koeffizient im Nullfeld" zur Charakterisierung einer magnetostriktiven Schicht als Begriff verwendet werden. Im Sinne der vorliegenden Beschreibung ist damit der Betrag von dλ/dH in Abwesenheit eines externen Magnetfeldes, oder kurz im Nullfeld, gemeint.

Eine "ungestützte" (d.h. nicht durch ein Stützfeld beeinflusste) und nicht vormagnetisierte magnetostriktive Schicht besitzt eine zu H = 0 symmetrische Magnetostriktionskurve und im Nullfeld einen piezomagnetischen Koeffizienten von praktisch Null. Wird demgegenüber ein Stützfeld der Stärke H_{B} nach dem Stand der Technik in der Schicht eingerichtet, so existiert eine energetisch begünstigte Vorzugsrichtung für die Ausrichtung der Elementardipole - eine magnetische Anisotropie - und der piezomagnetische Koeffizient im Nullfeld ist richtungsabhängig. Seinen größten Wert nimmt er dann in Richtung des Stützfeldes an.

Ein Stützfeld kann elektromagnetisch oder durch das Anordnen von permanentmagnetischem Material erzeugt werden. Bei der elektromagnetischen Stützfelderzeugung werden neue Rauschquellen eingeführt, die das Signal-zu-Rauschverhältnis der Sensoranordnung verschlechtern können. Die Verwendung von Permanentmagneten, die unmittelbar an den Rändern oder sogar innerhalb der magnetostriktiven Schicht angeordnet sind, erlaubt die Herstellung von so genannten "self-biased" ME-Sensoren, die sehr kleine Messfelder erfassen können (z.B. EP 0 729 122 A1).

Allerdings besitzen alle derzeit bekannten magnetostriktiven Schichten mit "selfbias" (immanentem Stützfe!d) eine von Null verschiedene Nettomagnetisierung und erzeugen somit auch magnetische Streufelder ("stray fields") in ihrer Umgebung. Dies ist insbesondere von Nachteil, wenn eine Mehrzahl magnetostriktiver Elemente in enger Nachbarschaft angeordnet wird, beispielsweise in einem ME-Sensor-Array für die ortsaufgelöste Magnetfeldmessung. Zudem stellt die monolithische Integration von Sensor und Stützfelderzeuger eine zusätzliche Hürde für die Miniaturisierung dar. Ferner würde jede Relativbewegung des Sensors zur Stützfeldanordnung aufgrund bereits kleinster Feldinhomogenitäten zu einer weiteren Rauschquelle führen.

ME-Sensor-Arrays sind gute Kandidaten für eine neue Generation biomagnetischer Detektoren, die in wichtigen Anwendungsfeldern alsbald die bisherige SQUID-Technologie ablösen könnte. Beispielsweise die Magnetfelder von Herz- oder auch Hirnströmen lassen sich - bevorzugt ortsaufgelöst und mit verschiedenen Feldkomponenten - an einem Probanden erfassen und im Prinzip auf die erzeugende Stromverteilung zurückrechnen (Quellenrekonstruktion). Denkbar ist in Zukunft sogar die Steuerung von Geräten (z.B. von Prothesen) über die magnetisch erfassten Hirnstrommuster. Supraleitende SQUIDs sind jedoch auf extreme Kühlung angewiesen, während ME-Sensoren auch bei Raumtemperatur Empfindlichkeiten bis in den Piko-Tesla-Bereich erreichen. Das Problem der Beherrschung der Streufelder bleibt noch zu lösen.

Aus der Arbeit von Vopsaroiu et al., "A new magnetic recording read head technology based on the magneto-electric effect", J. Phys. D: Appl. Phys. 40 (2007) 5027-5033, ist der Vorschlag zu entnehmen, magnetische Speichermedien über miniaturisierte ME-Sensoren auszulesen anstatt über den Magnetowiderstand nach dem Stand der Technik.

Die Autoren sind der Ansicht, dass die relativ großen, im Speichermedium eingeprägten magnetischen Momente (deren Orientierungen die Bits repräsentieren) auch in einer sehr dünnen Schicht magnetostriktiven Materials bereits eine piezoelektrisch messbare Längenänderung hervorrufen können. Ihnen ist dabei bewusst, dass die magnetostriktive Schicht dafür in einen günstigen Arbeitspunkt zu bringen ist, und so schlagen sie vor, dies durch die Austauschwechselwirkung mit einer antiferromagnetischen (AFM) Schicht zu erreichen, die unmittelbar auf oder unter der magnetostriktiven, ferromagnetischen (FM) Schicht angeordnet wird.

Die FM/AFM-Austauschwechselwirkung wird in der Literatur als "exchange bias" (EB) bezeichnet und seit ihrer Entdeckung 1956 intensiv theoretisch und experimentell untersucht. Bis heute existiert kein allgemeines Modell über ihr Zustandekommen, doch gilt es als gesichert, dass es sich um einen Grenzflächeneffekt zwischen AFM- und FM-Phase handelt. Als solcher ist der EB-Effekt von kurzer Reichweite, die im Wesentlichen durch die magnetische Austauschlänge (einige bis einige zehn Nanometer in den meisten Materialien) bestimmt ist.

Benutzt wird der EB-Effekt vor allem beim so genannten "pinning" magnetisierter Schichten in der digitalen Speichertechnologie, beispielsweise bei der Herstellung von "magnetic tunnel junctions" für "magnetic random access memory" (MRAM) oder magnetischen Leseköpfen. Durch das "pinning" wird eine einmal eingerichtete Magnetisierung einer FM-Schicht fixiert bzw. stabilisiert. Dies erfolgt etwa durch das Einkühlen einer FM/AFM-Doppelschicht ("bilayer") im Magnetfeld ("field annealing"), wobei zunächst die Curie-Temperatur unterschritten wird, um die Ausrichtung der Dipole in der FM-Schicht zu fixieren. Auch die Dipole der AFM-Schicht ordnen sich bei weiterer Abkühlung unter die Nöel-Temperatur und erzeugen so eine magnetische, unidirektionale Anisotropie in der FM-Schicht. Das Verdrehen oder Umklappen der Dipole in der FM-Schicht wird hierdurch erschwert, was sich am deutlichsten in einer Verschiebung der magnetischen HystereseKurve entlang der Anisotropie zeigt. Das Ausmaß der Verschiebung H_{EB} wird als Exchange-Bias-Feld(stärke) bezeichnet.

Weitere Informationen über Exchange Bias sowie umfangreiche Tabellen (insbesondere die Tabellen 2 - 4) mit antiferromagnetischen Materialien sind z.B. dem gleichnamigen Übersichtsartikel von Nogués und Schuller (Journal of Magnetism and Magnetic Materials 192 (1999) 203-232) zu entnehmen.

Der oben genannte Vorschlag von Vopsaroiu et al. hat einige öffentliche Aufmerksamkeit auf sich gezogen. Das Konzept für einen magnetischen Lesekopf, der ohne Teststrom zur Messung des Magnetowiderstands auskommt, ist sehr attraktiv für mobile Computer, die auf begrenzte Energiezellen angewiesen sind.

Gleichwohl scheint die Idee nicht viel weiter verfolgt worden zu sein. Insbesondere wurde der Gedanke eines AFM-basierten Stützfeldes für ME-Sensoren allem Anschein nach bislang nicht aufgegriffen. Da "self-biased" ME-Sensoren vor allem für die Detektion sehr kleiner Magnetfelder erforscht werden, überrascht dies nicht, denn man kann einige Probleme bei der Umsetzung des Konzepts erwarten:

Der EB-Effekt ist umso größer, je dünner die magnetostriktive FM-Schicht ist. Eine sehr dünne FM-Schicht wird gewöhnlich vollständig in eine Richtung gepinnt mit einem H_{EB} in der Größenordnung von leicht mehreren 100 Oe. Eine derart gepinnte Schicht zeigt praktisch keine Magnetostriktion mehr für relevante Magnetfelder, erst recht nicht in Pinning-Richtung.

Mit zunehmender Schichtdicke der FM-Schicht nimmt H_{EB} bekanntlich ab. Eine FM-Schicht kann einen Bereich in der Nähe der AFM/FM-Grenzfläche aufweisen, der für die Magnetostriktion günstig eingerichtet ist. Weiter entfernt liegende Schichtbereiche werden vom EB hingegen nicht erfasst. Es ist somit ungünstig für das Erzielen einer homogenen Magnetisierung in der FM-Schicht mit EB, wenn die Dicke der FM-Schicht zu groß gewählt wird.

Magnetostriktive Schichten werden für Aktuatoren bzw. in Kombination mit piezoelektrischen Schichten als magnetoelektrische Sensoren eingesetzt. In beiden Fällen skaliert die Effektgröße (Aktuator) bzw. die Empfindlichkeit (magnetoelektrischer Sensor) mit den Schichtdicken der magnetostriktiven Schichten.

Will man sehr kleine Magnetfelder detektieren, also sehr empfindliche magnetostriktive Schichten herstellen, so muss man hierfür eine ausreichende Menge magnetostriktiven Materials vorsehen. Aller Erfahrung nach erscheinen zur Detektion von Piko-Tesla-Flußdichten Materialvolumina der Größenordnung Kubikmillimeter angebracht. Mit magnetostriktiven Schichtdicken, die nach dem zuvor Gesagten auf einige zehn Nanometer begrenzt bleiben sollen, erscheint die Herstellung eines "exchange-biased" ME-Sensors für kleine Felder zunächst nicht aussichtsreich.

Es ist die Aufgabe der Erfindung, ein magnetostriktives Schichtsystem anzugeben, das einen hohen piezomagnetischen Koeffizienten im Nullfeld und zugleich ein möglichst kleines Streufeld aufweist und insbesondere zur Fertigung höchstempfindlicher ME-Sensoren geeignet ist.

Die Aufgabe wird gelöst durch ein Schichtsystem umfassend wenigstens eine antiferromagnetische (AFM-) Schicht und eine unmittelbar darauf angeordnete magnetostriktive, ferromagnetische (FM-) Schicht und aufweisend ein Exchange-Bias-(EB-) Feld gekennzeichnet durch einen EB-induzierten Magnetisierungsgrad der FM-Schicht im Nullfeld größer als 85 % und kleiner als 100 % und einen Winkel αₒₚₜ in der Schichtebene, den die EB-Feldrichtung und die Magnetostriktionsrichtung, die den maximalen piezomagnetischen Koeffizienten im Nullfeld aufweist, einschließen, der zwischen 10° und 80° liegt. Die Unteransprüche geben vorteilhafte Ausgestaltungen des Schichtsystems an.

Der vorgenannte maximale piezomagnetische Koeffizient liegt in derselben Größenordnung wie der piezomagnetische Koeffizient einer herkömmlich durch Permanentmagnete gestützten magnetostriktiven Schicht gleichen Materials.

Der Erfindung liegt die Erkenntnis zugrunde, dass der piezomagnetische Koeffizient im Nullfeld von der Richtung in der FM-Schicht abhängt, entlang der die Magnetostriktion stattfinden soll (Magnetostriktionsrichtung), wenn zuvor durch ein EB-Feld eine magnetische Anisotropie eingebracht worden ist. Der piezomagnetische Koeffizient im Nullfeld hängt insofern vom Winkel ab, den diese Richtung mit der EB-Feldrichtung in der Schichtebene einschließt. Er nimmt ein Maximum an für eine Richtung, die signifikant weder mit der EB-Feldrichtung übereinstimmt noch senkrecht zur EB-Feldrichtung liegt. Diese Richtung ist durch das Messen des maximalen piezomagnetischen Koeffizienten identifizierbar.

Der Magnetisierungsgrad wird erklärt als das Verhältnis M(H) / M(Hₛ), wobei M(H) die messbare Magnetisierung im externen Feld H und M(Hₛ) die Sättigungsmagnetisierung bezeichnen. Der Magnetisierungsgrad im Nullfeld ist folglich M(H=0) / M(Hₛ).

Das erfindungsgemäße Schichtsystem besitzt die Eigenschaft 0,85 < M(H=0) / M(Hₛ) < 1 und weist somit eine Nettomagnetisierung der wenigstens einen FM-Schicht (magn. Schichtmoment) auf. Der Magnetisierungsgrad kann gemessen werden, indem zunächst die Richtung und der Betrag des Schichtmoments bestimmt und hiernach entlang dieser Richtung eine magnetische Hysteresekurve aufgezeichnet wird. Die Richtung des Schichtmoments ist zugleich die Richtung des eingeprägten Exchange-Bias-Feldes.

Ein erfindungsgemäßes Schichtsystem ist durch eine Hysterekurve in Exchange-Bias-Feldrichtung gekennzeichnet, die auf einer Seite der Ordinate H = 0 bereits annähernd vollständige Magnetisierung zeigt. Insbesondere ist die wenigstens eine magnetostriktive FM-Schicht bereits im Nullfeld zu wenigstens 85 % durch Exchange Bias magnetisiert. Sie soll aber nicht vollständig magnetisiert sein, da dies bereits ein so starkes EB-Pinning bedeuten würde, dass sich die mangelnde Beweglichkeit der Elementarmagnete nachteilig auf die beabsichtigte Magnetostriktion auswirken würde. Die Wahl des Betrages des erfindungsgemäß im Schichtsystem eingerichteten EB-Feldes H_{EB} ist also nach oben beschränkt.

Das erfindungsgemäße Schichtsystem zeigt den maximalen piezomagnetischen Koeffizienten im Nullfeld entlang einer Richtung in der Schichtebene, die mit der Richtung des EB-Feldes den Winkel αₒₚₜ einschließt, wobei αₒₚₜ zwischen 10° und 80° liegt. Eine bevorzugte Ausgestaltung ist darin zu sehen, dass der Winkel αₒₚₜ zwischen den Winkeln 45° und 75° liegt. Der Winkel wird indirekt durch den Betrag des EB-Feldes bestimmt. Die genannte Winkeleingrenzung stellt insofern eine vorteilhafte Eingrenzung von H_{EB} dar.

Insbesondere kann mit dem erfindungsgemäßen Schichtsystem ein ME-Sensor hergestellt werden, der ein immanentes Stützfeld und einen hohen piezomagnetischen Koeffizienten sowie einen hohen magnetoelektrischen Spannungskoeffizienten im Nullfeld aufweist aber nur ein geringes oder sogar überhaupt kein Streufeld. Ein solcher ME-Sensor verfügt über eine vorbestimmte Messrichtung, die im Wesentlichen den Winkel αₒₚₜ mit der Richtung des EB-Feldes des Schichtsystems einschließt. Dieser Winkel beträgt wenigstens 10° und höchstens 80°. Bevorzugt beträgt er zwischen 45° und 75°.

Zur Herstellung des ME-Sensors kann das erfindungsgemäße Schichtsystem im Rahmen des fachmännischen Könnens auch mehrfach wiederholt aufeinander abgeschieden werden und so einen Schichtenstapel ("layer stack") bilden. Es kann vorteilhaft sein, nichtmagnetische Zwischenschichten zwischen den Wiederholungen der AFM/FM-Doppelschichten mit erfindungsgemäß eingerichtetem Exchange Bias vorzusehen. Der Zweck der Zwischenschichten wird weiter unten erläutert.

Die Erfindung wird im Weiteren noch näher erklärt auch anhand der folgenden Figuren. Dabei zeigt:
- Figur 1 die Hysteresekurve eines Schichtenstapels mit durch Exchange Bias (EB) gestützten magnetostriktiven Schichten in Richtung des EB-Feldes;
- Figur 2 die Magnetostriktionskurven des Schichtenstapels aus Fig. 1 für verschiedene Winkel zwischen Magnetfeld und EB-Feldrichtung, die die Winkelabhängigkeit des piezomagnetischen Koeffizienten verdeutlichen;
- Figur 3 ein berechneter Vergleich von Streufeldern zwischen einer EB-gestützten und einer permanentmagnetisch gestützten magnetostriktiven Schicht.

Ausgangspunkt der Erfindung ist die an sich bekannte Tatsache, dass der Betrag des in einer AFM/FM-Doppelschicht eingerichteten EB-Feldes mit heutigem Wissen im Allgemeinen nicht theoretisch vorhergesagt, sondern nur experimentell anhand der magnetischen Hysterekurve im Nachhinein festgestellt werden kann. Allein die Richtung des EB-Feldes ist vorab durch die Wahl der Richtung des Einkühlfeldes genau wählbar. Der Betrag des EB-Feldes kann hingegen durch Variation der Schichtdicke der FM-Schicht verändert werden; er nimmt mit wachsender Schichtdicke ab.

Folgt man zunächst Vopsaroiu et al., so müsste man ein EB-Feld schaffen, dessen Betrag H_{EB} gerade der Stützfeldstärke H_{B} entspricht, für die der piezomagnetische Koeffizient maximal wird, um die Empfindlichkeit in Richtung des EB-Feldes einzurichten. Allerdings sind H_{EB} und H_{B} nicht unabhängig voneinander variierbar, da sich beide mit der Dicke der FM-Schicht ändern, und es ist nicht klar, ob sich die Bedingung H_{EB} = H_{B} überhaupt für irgendeine Schichtdicke erfüllen lässt und falls ja, wie kompliziert die praktische Umsetzung ist.

Die Erfindungsidee ist deshalb, ein AFM/FM-Schichtsystem mit einer magnetostriktiven FM-Schicht zu schaffen, die durch ein EB-Feld in einen definierten magnetischen Zustand gebracht ist, und dann nach Magnetostriktion *entlang einer anderen Richtung in der Schichtebene als der des EB-Feldes* zu suchen. Man findet dabei eine Richtung, die sich durch maximalen piezomagnetischen Koeffizienten im Nullfeld auszeichnet und die einen Winkel αₒₚₜ mit der EB-Feldrichtung einschließt, der zwischen 10° und 80° liegt. Vorzugsweise liegt αₒₚₜ zwischen 45° und 75°.

Das erfindungsgemäße Schichtsystem lässt sich mit einem Gasphasenabscheidungsverfahren ("physical vapour deposition" wie z.B. Sputtern) herstellen.

Die Dicke der AFM-Schicht kann nach dem Stand der Technik so gewählt werden, dass eine weitere Erhöhung der AFM-Schichtdicke keinen Einfluss mehr auf den Betrag des EB-Feldes in der FM-Schicht hat. Gewöhnlich reicht hierfür eine Schichtdicke von wenigen Nanometern aus. Die AFM-Schichtdicke kann aber auch kleiner gewählt werden, solange sie nur eine stabile antiferromagnetische Phase ausbilden kann. Der Stand der Technik strebt möglichst hohe EB-Felder an, um FM-Schichten zu pinnen. In der vorliegenden Erfindung ist hingegen eine nach oben begrenzte EB-Feldstärke zweckmäßig. Die Dicke der FM-Schicht bestimmt die Exchange-Bias-Feldstärke H_{EB}.

Der Fachmann kann sich durch Vorversuche leicht Klarheit darüber verschaffen, ob für eine bestimmte Materialwahl des AFM/FM-Schichtsystems ein Exchange Bias im Sinne der Erfindung eingerichtet werden kann und mit welchen Schichtdicken dies gelingt.

Beispielsweise kann er einen Satz von Proben mit unterschiedlichen FM-Schichtdicken aber ansonsten gleich präparierten AFM-Schichten erzeugen, unter gleichen Bedingungen im Magnetfeld nacheinander unter Curie- und Néel-Temperatur abkühlen und hiernach die Hysteresekurven z.B. mit einem Vibrating Sample Magnetometer entlang der Einkühlrichtung aufzeichnen.

Es empfiehlt sich, die Proben im abgekühlten Zustand zunächst einigen magnetischen Umpolungen auszusetzen, um dem so genannten Trainingeffekt des Exchange Bias Rechnung zu tragen. Das EB-Feld wird hierdurch binnen weniger Zyklen auf einen stabilen Endwert gebracht.

Die Untersuchung der Hysterese der Proben sollte dann wenigstens eine, üblich mehrere Hysteresekurven ergeben, die anzeigen, dass sich eine oder mehrere Proben bereits im Nullfeld in der Nähe der magnetischen Sättigung befinden. Ein minimaler Magnetisierungsgrad von 85 % ist erfindungsgemäß erforderlich für einen definierten magnetischen Zustand.

Eine erfindungsgemäß bevorzugte Probe ist jene, bei der dies gerade eben eintritt, die also das dem Betrage nach kleinste EB-Feld besitzt, das zur wenigstens 85 %igen Magnetisierung der FM-Schicht der Probe im Nullfeld ausreicht. Durch diese Begrenzung ist das EB-Feld nicht so groß eingerichtet, dass die Dipole nicht mehr beweglich und durch kleine Magnetfelder unbeeinflussbar wären. Aus der beschriebenen Voruntersuchung lassen sich geeignete Schichtdicken für das erfindungsgemäße Schichtsystem unmittelbar ablesen.

Als ein erstes Ausführungsbeispiel kann ein erfindungsgemäßes Schichtsystem wie folgt realisiert werden:

Eine 2 nm dicke Schicht Tantal und eine darauf angeordnete 2 nm dicke Schicht Kupfer bilden eine Keimschicht für den Antiferromagneten. Auf dieser wird eine generell bevorzugt zwischen 3 nm und 8 nm, ganz besonders bevorzugt und hier beispielhaft 5 nm dicke AFM-Schicht aus Mn₇₀Ir₃₀ (at %) abgeschieden. Das magnetostriktive FM-Material Fe₅₀Co₅₀ wird auf der AFM-Schicht in einer generell bevorzugt zwischen 15 nm und 25 nm, ganz besonders bevorzugt und hier beispielhaft 20 nm dicken Schicht angeordnet.

Hier ist anzumerken, dass es einerseits polykristalline AFM-Materialien gibt, die auf praktisch beliebigen Substraten eine AFM-Phase ausbilden, und andererseits auch solche, die eine bestimmte kristalline Ordnung ("Textur") des Substrats hierfür benötigen. Liegt diese nicht vor, kann man sich durch das Anordnen einer zusätzlichen Keimschicht behelfen. Im Ausführungsbeispiel hat das nanokristalline Tantal die Aufgabe, die Textur des Substrats "zu löschen" bzw. für die darüber angeordneten Materialien unsichtbar zu machen. Die darauf abgeschiedene Kupferschicht stellt dann ein günstiges Substrat zur Ausbildung der AFM-Phase in der Mangan-Iridium-Legierung bereit.

Das Schichtsystem des Ausführungsbeispiels ist hinsichtlich der Materialwahl der Arbeit von G. Reiss, D. Meyners, "Logic based on magnetic tunnel junctions", J. Phys.: Condens. Matter 19 (2007), 165220 (12pp) entliehen.

Das Schichtsystem des ersten Ausführungsbeispiels lässt sich durch Wiederholen als Schichtenstapel ausführen, da die "texturlöschende" Wirkung des Tantals auch bei den Wiederholungen der Schichtabfolge eintritt. Das Tantal wird bei allen Wiederholungen auf einer magnetostriktiven FM-Schicht angeordnet.

Als ein zweites Ausführungsbeispiel wird ein magnetostriktiver Schichtenstapel mit insgesamt 40 Wiederholungen des Ta/Cu/Mn₇₀Ir₃₀/Fe₅₀Co₅₀-Schichtsystems - wie im ersten Ausführungsbeispiel beschrieben - realisiert. Dieser besitzt eine Gesamtdicke von 1200 nm, wobei Zweidrittel des Volumens durch magnetostriktives Material gebildet sind. Es lassen sich somit etwa 10⁸ µm³ magnetostriktives Material pro Quadratzentimeter Querschnittsfläche auf ein Substrat bringen, was im Rahmen des gängigen Designs von hochempfindlichen ME-Sensoren liegt, die mittels Dünnschichttechnologien hergestellt werden.

Ein erfindungsgemäßes Schichtsystem kann durch Beschichten eines Substrates (z.B. Silizium-Wafer) erzeugt und hiernach als Ganzes vom Substrat abgelöst werden. Es kann somit substratfrei ausgebildet sein.

In der nachfolgenden Übersichtstabelle sind weitere zur Realisierung der Erfindung geeignete Materialsysteme aufgeführt. Die Schichtdicken (insbesondere zur Einstellung von H_{EB}) und Winkel gegen die EB-Feldrichtung mit maximalem piezomagnetischem Koeffizienten im Nullfeld lassen sich anhand von Proben wie weiter oben beschrieben bestimmen. Die Tiefzahlen an den Elementen in der Tabelle bezeichnen die Mischungsverhältnisse in Atomprozent (at %). Weitere Hinweise sind den Fußnoten der Tabelle zu entnehmen.

| Beispiele für erfindungsgemäße Schichtsysteme^{a} | | |
|---|---|---|
| Keimschicht oder Keimschichtsystem ^{b} | Antiferromagnetische Schicht | Magnetostriktive Schicht oder magnetostriktives Schichtsystem ^{b} |
| | | |
| Ta / Cu | Mn₇₀Ir₃₀^{c} | Co₅₀Fe₅₀^{d} |
| Ta / Cu | Mn₇₀Ir₃₀^{c} | Co₄₀Fe₄₀B₂₀^{f} |
| Ta / Cu | Mn₇₀Ir₃₀^{c} | Co₅₀Fe₅₀^{d} Co₄₀Fe₄₀B₂₀^{f} |
| Ta / Cu | Mn₇₀Ir₃₀^{c} | Co₅₀Fe₅₀^{d} / Fe₇₀Co₈B₁₂Si₁₀^{g} |
| Ta / Cu | Mn₇₀Ir₃₀^{c} | Co₅₀Fe₅₀^{d} / Tb₃₅Fe₆₅^{d} |
| | | |
| Ta / Ni₈₀Fe₂₀^{d} | Mn₇₀Ir₃₀^{c} | Co₅₀Fe₅₀^{d} |
| Ta / Ni₈₀Fe₂₀^{d} | Mn₇₀Ir₃₀^{c} | Co₄₀Fe₄₀B₂₀^{f} |
| Ta / Ni₈₀Fe₂₀^{d} | Mn₇₀Ir₃₀^{c} | Co₅₀Fe₅₀^{d} / Co₄₀Fe₄₀B₂₀^{f} |
| Ta / Ni₈₀Fe₂₀^{d} | Mn₇₀Ir₃₀^{c} | Co₅₀Fe₅₀^{d} / Fe₇₀Co₈B₁₂Si₁₀^{g} |
| Ta / Ni₈₀Fe₂₀^{d} | Mn₇₀Ir₃₀^{c} | Co₅₀Fe₅₀^{d} / Tb₃₅Fe₆₅^{d} |
| | | |
| Ta | Mn₇₀Ir₃₀^{c} | Co₅₀Fe₅₀^{d} |
| Ta | Mn₇₀Ir₃₀^{c} | Co₄₀Fe₄₀B₂₀^{f} |
| Ta | Mn₇₀Ir₃₀^{c} | Co₅₀Fe₅₀^{d} / Co₄₀Fe₄₀B₂₀^{f} |
| Ta | Mn₇₀Ir₃₀^{c} | Co₅₀Fe₅₀^{d} / Fe₇₀Co₈B₁₂Si₁₀^{g} |
| Ta | Mn₇₀Ir₃₀^{c} | Co₅₀Fe₅₀^{d} / Tb₃₅Fe₆₅^{d} |
| | | |
| TaN / Ta | Pt₅₀Mn₅₀^{e} | Co₅₀Fe₅₀^{d} |
| TaN / Ta | Pt₅₀Mn₅₀^{e} | Co₅₀Fe₅₀^{d} / Co₄₀Fe₄₀B₂₀^{f} |
| TaN / Ta | Pt₅₀Mn₅₀^{e} | Co₅₀Fe₅₀^{d} / Fe₇₀Co₈B₁₂Si₁₀^{g} |
| TaN / Ta | Pt₅₀Mn₅₀^{e} | Co₅₀Fe₅₀^{d} / Tb₃₅Fe₆₅^{d} |
| | | |
| Ta / Cu / NiFe | Fe₅₀Mn₅₀^{h} | Im Keimschichtsystem enthalten |
| | | |
| ^{a} Die Schichtsysteme werden durch die in den Zeilen genannten Materialien gebildet. Dabei ist die Stapelfolge gegeben durch Keimschicht, antiferromagnetische Schicht und magnetostriktive Schicht. Die Schichtsysteme können mehrfach wiederholt aufeinander abgeschieden werden können. | | |
| ^{b} Keimschichten oder magnetostriktive Schichten können auch aus mehreren Einzelschichten verschiedener Materialien bestehen. In der Tabelle werden solche Einzelschichten durch das Zeichen / voneinander getrennt dargestellt. Die zuerst genannte Einzelschicht wird auch zuerst aufgebracht, sodass die Notation die Stapelfolge wiedergibt. | | |
| ^{c} Mnlr muss in der antiferromagnetischen Phase vorliegen, was zum Beispiel für die angegebene Legierungszusammensetzung in Atomprozent in an sich bekannter Weise zu erreichen ist. Für das erfindungsgemäße Schichtsystem sind alle Zusammensetzungen zwischen Mn₇₀Ir₃₀ und Mn₈₀Ir₂₀ geeignet. | | |
| ^{d} bevorzugte Legierungszusammensetzung in Atomprozent | | |
| ^{f} bevorzugte Legierungszusammensetzung in Atomprozent; der Borgehalt sollte bei etwa zwanzig Atomprozent liegen, um eine amorphe Schicht zu generieren. | | |
| ^{g} bevorzugte Legierungszusammensetzung in Atomprozent; der Gehalt der Glasbildner (Bor und Silizium) sollte bei etwa zwanzig Atomprozent liegen, um eine amorphe Schicht zu generieren. | | |
| ^{e} PtMn muss in der antiferromagnetischen Phase vorliegen, was zum Beispiel für die angegebene Legierungszusammensetzung in Atomprozent durch Wärmebehandlung zu erreichen ist. Für das erfindungsgemäße Schichtsystem sind alle Zusammensetzungen zwischen Pt₃₅Mn₆₅ und Pt₄₄Mn₅₆ geeignet. | | |
| ^{h} bevorzugte Legierungszusammensetzung in Atomprozent; FeMn muss in der antiferromagnetischen Phase vorliegen. | | |

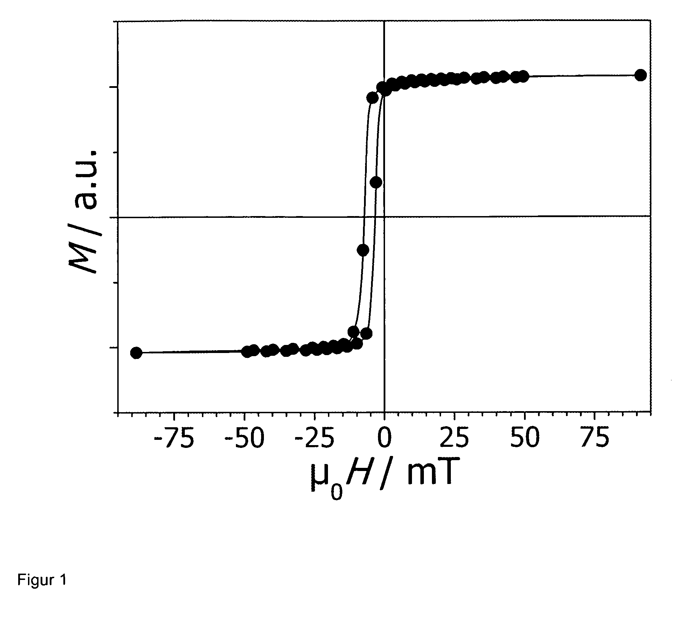

Figur 1 zeigt die gemessene Hysteresekurve des Schichtenstapels gemäß dem zweiten Ausführungsbeispiel in Richtung des beim Einrichten des Exchange Bias verwendeten Einkühlfeldes. Das Vorliegen einer wenigstens 85 %igen Magnetisierung der FM-Schichten im Schichtenstapel auf einer Seite der Ordinate bei H = 0 infolge des eingeprägten EB-Feldes ist ein Kennzeichen des erfindungsgemäßen Schichtsystems.

Wie bereits erwähnt ist das Bilden von Schichtenstapeln dem Fachmann geläufig. Ebenso ist ihm beispielsweise aus der US 2011/062955 A1 bekannt, dass man ME-Sensoren als Schichtenstapel umfassend je eine Mehrzahl magnetostriktiver und piezoelektrischer Schichten in alternierender Reihenfolge ausführen kann. Es ist folglich auch möglich, ME-Sensoren herzustellen, die piezoelektrische Schichten und erfindungsgemäße magnetostriktive Schichtsysteme in alternierender Reihenfolge aufweisen.

Alternativ kann auch ein magnetostriktiver Schichtenstapel, der wie oben beschrieben als eine Wiederholung des erfindungsgemäßen Schichtsystems ausgebildet ist, als Ganzes mit einer einzelnen piezoelektrischen Schicht verbunden werden, um einen ME-Sensor zu schaffen. Diese Möglichkeit ist aufgrund der wesentlich einfacheren lithographischen Strukturierung im Fall metallischer / leitender Magnetostriktiva zu bevorzugen.

Untersucht man die Magnetostriktion des Schichtenstapels gemäß dem zweiten Ausführungsbeispiel unter verschiedenen Winkeln 0 < α ≤ 90° gegenüber der eingeprägten Richtung des EB-Feldes, so stellt man fest, dass die Magnetostriktionskurve nunmehr in Abhängigkeit von α verschoben wird und auch ihren qualitativen Verlauf ändert.

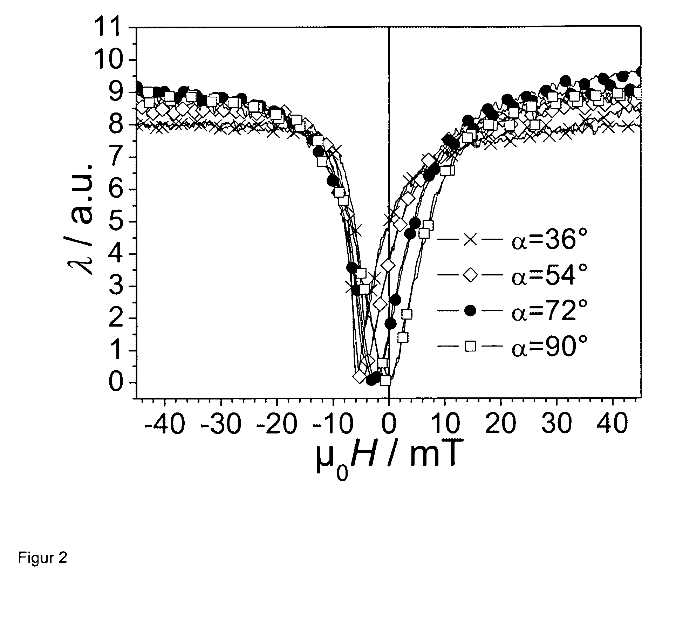

Figur 2 zeigt gemessene Magnetostriktionskurven für das zweite Ausführungsbeispiel entlang Richtungen, die um den Winkel αₒₚₜ = 36°, 54°, 72° und 90° gegen die EB-Richtung gedreht sind. Der Fall 90° entspricht dabei dem bekannten symmetrischen Verhalten der Magnetostriktionskurve, wenn die Dipole der FM-Schicht gerade senkrecht zur Richtung des Magnetfeldes ausgerichtet sind, das die Magnetostriktion bewirkt. In den anderen Fällen zeigt sich Asymmetrie und insbesondere ein mehr oder weniger starker Anstieg dλ/dH bei H = 0. Die Richtung mit dem größten piezomagnetischen Koeffizienten dλ/dH im Nullfeld wird hier bei αₒₚₜ = 54° ermittelt.

Die Abweichung der Richtung des eingeprägten EB-Feldes (die anhand des Auftretens der maximalen Verschiebung der Hysteresekurve bezüglich H auch nach der Fertigstellung des Schichtsysteme jederzeit feststellbar ist) von der Richtung in der Schichtebene, in der der maximale piezomagnetische Koeffizient im Nullfeld messbar ist, um einen Winkel αₒₚₜ, der zwischen 10° und 80°, bevorzugt zwischen 45° und 75°, liegt, ist ein weiteres Kennzeichen des erfindungsgemäßen Schichtsystems.

Der genaue Wert des Winkels αₒₚₜ lässt sich nicht allgemein angeben, sondern er ist für jedes konkrete Schichtsystem - bei Vorgabe der Materialien und Schichtdicken - anhand einer winkelaufgelösten Untersuchung der Magnetostriktion zu messen. Er ist jedoch nur einmal für das Schichtsystem zu bestimmen. Wird ein Schichtsystem mit geringfügigen Abweichungen von einem bereits bekannten erzeugt, so kann eine Anpassung von αₒₚₜ erforderlich sein.

Dank der nachträglichen Einstellbarkeit von αₒₚₜ kommt es nicht zu sehr auf den genauen Betrag des eingeprägten EB-Feldes an. Wird H_{EB} etwas größer als nötig eingerichtet, also insbesondere derart, dass der Magnetisierungsgrad der wenigstens einen FM-Schicht im Nullfeld 85 % übersteigt, so findet man die Richtung mit maximalem piezomagnetischen Koeffizienten im Nullfeld dann unter einem etwas größeren Winkel αₒₚₜ.

Hat man mehrere Möglichkeiten - z.B. mehrere Proben in den Voruntersuchungen - zur Einrichtung eines EB-Feldes, das einen erfindungsgemäß geeigneten Magnetisierungsgrad der FM-Schichten im Nullfeld bewirkt, so ist es vorteilhaft, von diesen Möglichkeiten jene auszuwählen, die den Winkel αₒₚₜ in das Intervall zwischen 45° und 75° bringt.

Das Aufsuchen von αₒₚₜ entspricht gewissermaßen der Feinjustierung des EB-Feldes in Stützrichtung. Das Fehlen einer solchen Feinjustierung bei Vopsaroiu et al. stand bislang der praktischen Umsetzung entgegen. Mit den hier beschriebenen Mitteln lassen sich nunmehr "EB-Feld-gestützte" magnetostriktive Schichtsysteme mit hohem piezomagnetischen Koeffizienten im Nullfeld herstellen und anwenden.

Zur Herstellung von ME-Sensoren für sehr kleine Messfelder ist man auf das Erzeugen EB-Feld-gestützter Schichtenstapel angewiesen, um genug magnetostriktives Material zu haben. Die Aussagen über die Verschiebung der Hysteresekurve und die Winkelabhängigkeit des piezomagnetischen Koeffizienten im Nullfeld gelten genauso für ein einzelnes erfindungsgemäßes Schichtsystem wie für einen Schichtenstapel, der eine Mehrzahl von Wiederholungen des Schichtsystems umfasst. Tatsächlich lassen sich Hysterese und Magnetostriktion an einem Schichtenstapel sogar leichter messen. Das EB-Feld wird gewöhnlich erst nach der Fertigstellung des Schichtenstapels in diesen eingeprägt. Danach wird der Winkel αₒₚₜ identifiziert.

Im Falle eines ME-Sensors ist das Substrat beispielsweise üblich ein rechteckiger Streifen, z.B. aus Si oder auch aus einem Glas, der zunächst mit piezoelektrischem Material beschichtet worden ist. Das Substrat kann auch ein Piezoelektrikum sein, welches selbst freitragend ausgebildet ist. Zum Beispiel Unter- und Oberseite des Komposits werden für den Spannungsabgriff mit Elektroden kontaktiert.

Ein ME-Sensor besitzt stets eine ausgezeichnete Achse, entlang der die Magnetostriktion ausgenutzt werden soll und wo sie deshalb maximal sensitiv zu sein hat. Im Falle des rechteckigen Streifens ist dies z.B. die längere Achse. Nachdem der erfindungsgemäße Schichtenstapel auf dem Piezoelektrikum angeordnet worden ist, wird das Stützfeld vorzugsweise durch Einkühlen im Magnetfeld eingeprägt. Alternativ kann das intrinsische Stützfeld auch während der Abscheidung des magnetostriktiven Materials z.B. durch Sputtern in einem Magnetfeld erzeugt werden. In allen Fällen ist es erforderlich das Magnetfeld, das die Richtung des EB-Feldes bestimmt, um den Winkel αₒₚₜ gegen die ausgezeichnete Achse des ME-Sensors zu verdrehen. Auf diese Weise besitzt das magnetostriktive Schichtsystem gerade genau entlang der ausgezeichneten Richtung seinen maximalen piezomagnetischen Koeffizienten im Nullfeld, im Beispiel des Streifens also z.B. entlang der Längsachse und damit der vorgesehenen Messrichtung des ME-Sensors.

Alternativ kann man den Schichtenstapel großflächig z.B. auf ein Flächensubstrat (z.B. einen Wafer) aufbringen, der zuvor mit einem elektrisch kontaktierten Piezoelektrikum versehen worden ist. Der gesamte Wafer kann dann im Einkühlfeld behandelt und im Anschluss in streifenförmige ME-Sensoren vereinzelt werden. Dabei ist nun zu bedenken, dass die Richtung der Vereinzelung - gemeint ist die Richtung der langen Achsen der vereinzelten Streifen - mit dem Einkühlfeld den Winkel αₒₚₜ einzuschließen hat, damit man möglichst empfindliche ME-Sensoren erhält.

Das hier beschriebene magnetostriktive Schichtsystem hat den wesentlichen Vorteil einer stark verringerten Nettomagnetisierung durch den Verzicht auf Permanentmagneten. Einzig die durch Exchange Bias eingeführte Anisotropie sorgt noch dafür, dass die begünstigte Ausrichtung der Elementardipole in jeder magnetostriktiven Schicht ein magnetisches Nettomoment erzeugt. Dieses ist jedoch klein gegenüber den Feldstärken der Permanentmagnete, die man sonst für das Stützfeld bräuchte. Überdies ist die Gleichmäßigkeit der Dipolausrichtung - d.h. die Homogenität des Stützfeldes - durch den EB-Effekt praktisch garantiert, was für sich genommen schon eine Verbesserung gegenüber dem Stand der Technik ist.

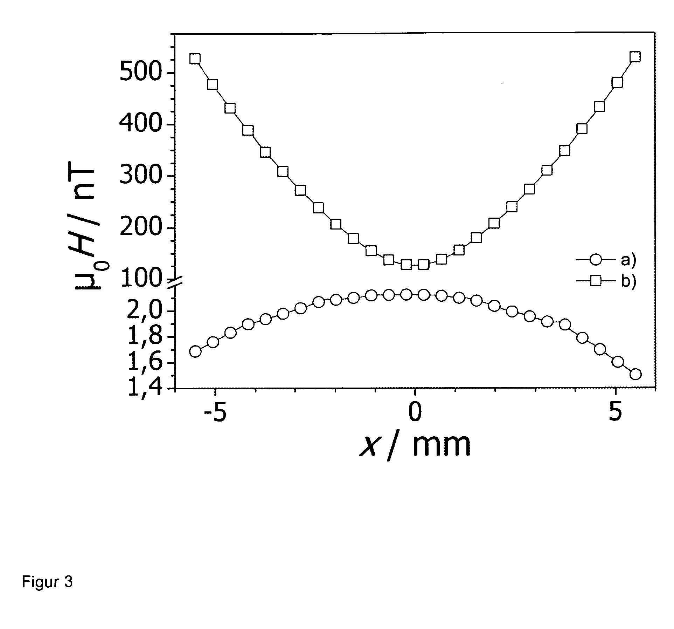

Da sich Streufelder nur mit erheblichem Aufwand messen lassen, soll eine numerische Modellrechnung hier ausreichen, den Effekt der Erfindung zu illustrieren. Figur 3 zeigt den berechneten Feldverlauf in der Nachbarschaft eines ferromagnetischen, magnetostriktiven Rechteckstreifens parallel zu seiner Längsachse (x-Achse) für a) eine erfindungsgemäße EB-Vormagnetisierung (mit αₒₚₜ = 60°, d.h. ein AFM-Streifen pinnt durch Austauschwechselwirkung die Dipole mit einem Winkel von 60° gegen die Längsachse) und für b) eine Permanentmagnetanordnung mit Hauptfeldrichtung entlang der Längsachse. Die Permanentmagnete aus AlNiCo sind so groß gewählt, dass ihr Magnetfeld am Ort des ferromagnetischen Rechteckstreifens im Mittel 5 Oe beträgt und um nicht mehr als ± 10% variiert. Die Magnetfelder im Mittelpunkt (x = 0) eines zweiten, benachbarten Rechteckstreifens respektive Sensors betragen im Fall a) ca. 2 nT und im Fall b) ca. 100 nT.

## Patentansprüche

1. Schichtsystem umfassend mindestens eine Schichtenfolge aus
■ einer antiferromagnetische, AFM-, Schicht und
■ einer unmittelbar darauf angeordneten magnetostriktiven, ferromagnetischen, FM-, Schicht,
wobei die Schichtenfolge ein zugeordnetes Exchange-Bias, EB-, Feld aufweist,
**dadurch gekennzeichnet, dass**
□ der EB-induzierte Magnetisierungsgrad der FM-Schicht in Abwesenheit eines externen Magnetfeldes in einem Bereich zwischen 85 % und 100 % liegt und
□ der Winkel αₒₚₜ, den die EB-Feldrichtung und die Magnetostriktionsrichtung, die den maximalen piezomagnetischen Koeffizienten in Abwesenheit eines externen Magnetfeldes aufweist, innerhalb einer Ebene parallel zu der AFM- Schicht und der FM- Schicht einschließen, in einem Bereich zwischen 10° und 80° liegt.

2. Schichtsystem nach Patentanspruch 1, **dadurch gekennzeichnet, dass** der Winkel αₒₚₜ in einem Bereich zwischen 45° und 75° liegt.

3. Schichtsystem nach einem der Patentansprüche 1 und 2, **dadurch gekennzeichnet, dass** die Dicke der AFM- Schicht der mindestens einen Schichtenfolge in einem Bereich von 3 nm bis 8 nm liegt.

4. Schichtsystem nach einem der Patentansprüche 1 bis 3, **dadurch gekennzeichnet, dass** die Dicke der FM- Schicht der mindestens einen Schichtenfolge in einem Bereich von 15 nm bis 25 nm liegt.

5. Schichtsystem nach einem der Patentansprüche 1 bis 4, **dadurch gekennzeichnet, dass** das Verhältnis
Dicke einer AFM- Schicht : Dicke einer FM- Schicht
innerhalb einer Schichtenfolge in einem Bereich zwischen 1 : 8 bis 1 : 2 liegt.

6. Schichtsystem nach Patentanspruch 5, **dadurch gekennzeichnet, dass** die Dicken der AFM- Schichten und die Dicken der FM- Schichten unterschiedlicher Schichtenfolgen innerhalb eines Schichtensystems identisch sind.

7. Schichtsystem nach einem der Patentansprüche 1 bis 6, **dadurch gekennzeichnet, dass** die mindestens eine Schichtenfolge aus einer AFM- Schicht und einer FM-Schicht substratfrei ausgebildet ist.

8. Schichtsystem nach einem der Patentansprüche 1 bis 7, **dadurch gekennzeichnet, dass** die AFM- Schicht der mindestens einen Schichtenfolge aus einem Material besteht oder dieses umfasst, ausgesucht aus der Liste, umfassend: Mn₇₀Ir₃₀, Pt₅₀Mn₅₀, Fe₅₀Mn₅₀.

9. Schichtsystem nach einem der Patentansprüche 1 bis 8, **dadurch gekennzeichnet, dass** die FM- Schicht der mindestens einen Schichtenfolge aus einem Material besteht oder dieses umfasst, ausgesucht aus der Liste, umfassend: Co₅₀Fe₅₀, Co₄₀Fe₄₀B₂₀, Fe₇₀Co₈B₁₂Si₁₀, Tb₃₅Fe₆₅.

10. Magnetoelektrischer, ME-, Sensor zur Magnetfeldmessung **gekennzeichnet durch** wenigstens ein Schichtsystem nach einem der Patentansprüche 1 bis 9 in mechanischer Kopplung mit wenigstens einer piezoelektrischen Schicht, wobei die vorbestimmte Messrichtung des Sensors im Wesentlichen den Winkel αₒₚₜ mit der Richtung des EB-Feldes des Schichtsystems einschließt.

11. Verfahren zur Herstellung von ME-Sensoren nach Patentanspruch 10, umfassend mindestens die Verfahrensschritte:
i) Beschichten eines Flächensubstrats mit einem elektrisch kontaktierten Piezoelektrikum;
ii) Aufbringen eines Schichtsystems nach einem der Ansprüche 1 bis 10, wobei die Richtung des EB-Feldes durch Vorgabe eines externen Magnetfeldes bestimmt wird;
iii) Vereinzeln des beschichteten Flächensubstrats in rechteckige Streifen, wobei die lange Achse der Streifen als Messrichtung vorgesehen ist und mit der vorbekannten Richtung des EB-Feldes den aus Voruntersuchungen bekannten Winkel αₒₚₜ einschließt.

## Claims

1. Layer system comprising at least one layer sequence comprising
■ an antiferromagnetic, AFM, layer and
■ a magnetostrictive, ferromagnetic, FM, layer arranged directly thereon
wherein the layer sequence has an associated exchange bias, EB, field,
**characterised in that**
□ the EB-induced degree of magnetisation of the FM layer in an absence of an external magnetic field lies within a range between 85% and 100% and
□ the angle αₒₚₜ, which is enclosed by the EB field direction and the magnetostriction direction, that has the maximum piezomagnetic coefficient in the absence of an external magnetic field, within a plane parallel to the AFM layer and the FM layer lies within a range between 10° and 80°.

2. The layer system according to claim 1, **characterised in that** the angle αₒₚₜ lies within a range between 45° and 75°.

3. The layer system according to claim 1 or 2, **characterised in that** the thickness of the AFM layer of the at least one layer sequence lies within a range of 3 nm to 8 nm.

4. The layer system according to one of claims 1 to 3, **characterised in that** the thickness of the FM layer of the at least one layer sequence lies within a range of 15 nm to 25 nm.

5. The layer system according to one of claims 1 to 4, **characterised in that** the ratio of
thickness of an AFM layer : thickness of an FM layer
within a layer sequence lies within a range between 1:8 to 1:2.

6. The layer system according to claim 5, **characterised in that** the thicknesses of the AFM layers and the thicknesses of the FM layers of different layer sequences within a layer system are identical.

7. The layer system according to one of claims 1 to 6, **characterised in that** the at least one layer sequence consisting of an AFM layer and an FM layer is embodied as substrate-free.

8. The layer system according to one of claims 1 to 7, **characterised in that** the AFM layer of the at least one layer sequence consists of or comprises a material selected from the list comprising: Mn₇₀Ir₃₀, Pt₅₀Mn₅₀, Fe₅₀Mn₅₀.

9. The layer system according to one of claims 1 to 8, **characterised in that** the FM layer of the at least one layer sequence consists of or comprises a material selected from the list comprising: Co₅₀Fe₅₀, Co₄₀Fe₄₀B₂₀, Fe₇₀Co₈B₁₂Si₁₀, Tb₃₅Fe₆₅.

10. Magnetoelectric, ME, sensor for measuring a magnetic field **characterised by** at least one layer system according to one of claims 1 to 9 in mechanical coupling with at least one piezoelectric layer, wherein the predetermined measuring direction of the sensor substantially encloses the angle αₒₚₜ with the direction of the EB field of the layer system.

11. Method for a production of an ME sensor according to claim 10, comprising at least steps of:
i) coating a flat substrate with an electrically contacted piezoelectric;
ii) applying a layer system according to one of claims 1 to 10, wherein the direction of the EB field is determined by presetting an external magnetic field;
iii) isolating the coated flat substrate in rectangular strips, wherein the long axis of the strips is intended to be the measuring direction and encloses the angle αₒₚₜ, which is known from previous experiments, with the previously known direction of the EB field.

## Revendications

1. Système de couches comprenant au moins une série de couches constituée
- d'une couche antiferromagnétique, AFM, et
- d'une couche ferromagnétique, FM, magnétostrictive, disposée directement sur cette dernière,
la série de couches présentant un champ exchange bias, EB, associé,
**caractérisé en ce que**
- le degré de magnétisation induit EB de la couche FM, en l'absence d'un champ magnétique externe, se situe dans une plage comprise entre 85% et 100%, et
- l'angle αₒₚₜ, que forment la direction de champ EB et la direction de magnétostriction, qui présente le coefficient piézomagnétique maximal en l'absence d'un champ magnétique externe, à l'intérieur d'un plan parallèle à la couche AFM et à la couche FM, se situe dans une plage comprise entre 10° et 80°.

2. Système de couches selon la revendication 1, **caractérisé en ce que** l'angle αₒₚₜ se situe dans une plage comprise entre 45° et 75°.

3. Système de couches selon l'une des revendications 1 et 2, **caractérisé en ce que** l'épaisseur de la couche AFM de la au moins une série de couches se situe dans une plage de 3 nm à 8 nm.

4. Système de couches selon l'une des revendications 1 à 3, **caractérisé en ce que** l'épaisseur de la couche FM de la au moins une série de couches se situe dans une plage de 15 nm à 25 nm.

5. Système de couches selon l'une des revendications 1 à 4, **caractérisé en ce que** le rapport
épaisseur d'une couche AFM : épaisseur d'une couche FM
à l'intérieur d'une série de couches se situe dans une plage comprise entre 1 : 8 et 1 : 2.

6. Système de couches selon la revendication 5, **caractérisé en ce que** les épaisseurs des couches AFM et les épaisseurs des couches FM de séries de couches différentes sont identiques à l'intérieur d'un système de couches.

7. Système de couches selon l'une des revendications 1 à 6, **caractérisé en ce que** la au moins une série de couches constituée d'une couche AFM et d'une couche FM est formée sans substrat.

8. Système de couches selon l'une des revendications 1 à 7, **caractérisé en ce que** la couche AFM de la au moins une série de couches est constituée d'un matériau ou renferme ce dernier, choisi parmi la liste comprenant : Mn₇₀Ir₃₀, Pt₅₀Mn₅₀, Fe₅₀Mn₅₀.

9. Système de couches selon l'une des revendications 1 à 8, **caractérisé en ce que** la couche FM de la au moins une série de couches est constituée d'un matériau ou renferme ce dernier, choisi parmi la liste comprenant : Co₅₀Fe₅₀, Co₄₀Fe₄₀B₂₀, Fe₇₀Co₈B₁₂Si₁₀, Tb₃₅Fe₆₅.

10. Capteur magnétoélectrique ME pour la mesure du champ magnétique, **caractérisé par** au moins un système de couches selon l'une des revendications 1 à 9 dans un couplage mécanique avec au moins une couche piézoélectrique, la direction de mesure prédéfinie du capteur formant essentiellement l'angle αₒₚₜ avec la direction du champ EB du système de couches.

11. Procédé de fabrication de capteurs ME selon la revendication 10, comprenant au moins les étapes de procédé :
i) revêtement d'un substrat superficiel par un piézoélectrique à contact électrique ;
ii) application d'un système de couches selon l'une des revendications 1 à 10, la direction du champ EB étant déterminée par prédéfinition d'un champ magnétique externe ;
iii) séparation du substrat superficiel revêtu en bandes rectangulaires, l'axe longitudinal des bandes étant prévu en tant que direction de mesure et formant avec la direction préalablement connue du champ EB l'angle αₒₚₜ connu par des recherches préliminaires.
